# EUROPEAN PATENT APPLICATION

(11) **EP 1 160 859 A2**
(43) Date of publication of application: **05.12.2001**
(21) Application number: 01304505.9
(22) Date of filing: 23.05.2001
(51) Int. Cl.: H01L 23/31, H01L 23/60

(54) **Surface-mounting type electronic circuit unit suitable for miniaturization and easy to manufacture**

(30) Priority: 30.05.2000 JP 2000160229
(71) Applicant: ALPS ELECTRIC CO., LTD., Ota-ku Tokyo 145 (JP)
(72) Inventor: Inoue, Akihiko, Ota-ku, Tokyo 145 (JP)
(74) Representative: Kensett, John Hinton

(57) **Abstract**

To provide a surface-mounting type electronic circuit unit provided with a shield, suitable for miniaturization and easy to manufacture, a circuit element (3) such as a resistor and a capacitor and a conductive pattern are thinly formed on a square and flat substrate (1) made of alumina, a semiconductor bare chip (4) such as a transistor is bonded via wire and a part of the conductive pattern is exposed at the edge of the substrate so as to form an earth pattern. An insulating passivation layer (6) is formed in a region except the earth pattern (5) of the substrate, the circuit element and the semiconductor bare chip are covered with the insulating passivation layer and the upper surface of the insulating passivation layer is flattened by pressing and others. A metallic shield (2) is bonded on the upper surface of the insulating passivation layer using a conductive adhesive (7), and the shield and the earth pattern are electrically connected via the conductive adhesive by also applying the conductive adhesive on the earth pattern.

## Description

### BACKGROUND OF THE INVENTION

### 1. Field of the Invention

The present invention relates to a surface-mounting type electronic circuit unit mounted by soldering on a soldering land on a mother board (a printed wiring substrate), particularly relates to a surface-mounting type electronic circuit unit to which a shield is attached.

### 2. Description of the Related Art

Generally, for such a surface-mounting type electronic circuit unit, a surface-mounting type electronic circuit unit is known which is formed by soldering circuit components such as a chip resistor, a chip capacitor and a transistor on a substrate and providing plural end-face electrodes on the end face of the substrate and formed so that the circuit components are covered with a shield if necessary. The shield is formed by folding a metallic plate in the shape of a box and is attached to the substrate by soldering a leg piece folded on the margin on a part of the end-face electrode so that the shield covers the circuit components.

As the surface-mounting type electronic circuit unit substantially configured as described above is mounted by soldering the end-face electrode exposed on the end face of the substrate on a soldering land on a mother board, it has an advantage that a mounting density can be greatly enhanced compared with an electronic component having lead wire of which the lead terminal protruded from the end face of the substrate is soldered in a through hole of the mother board and the demand will increase more and more in the future.

Recently, technology for miniaturizing a circuit component such as a chip resistor and a chip capacitor has remarkably progressed, and microminiature chip resistor and chip capacitor the outside dimension of which is approximately 0.6 × 0.3 mm for example are also realized. Therefore, if such a miniature chip component and a transistor are also used in the abovementioned prior art and these circuit components are mounted on a substrate in a state in which pitch between components is narrowed, a surface-mounting type electronic circuit unit can be miniaturized to some extent.

However, the miniaturization of a circuit component such as a chip component and a transistor has a limit and in addition, as a part in which each circuit component is soldered is required to be prevented from being short-circuited when multiple circuit components are mounted on a substrate, the reduction of pitch between components also has a limit and these have prevented the further miniaturization of a surface-mounting type electronic circuit unit. As the outside dimension of a substrate and a shield is also reduced when a surface-mounting type electronic circuit unit is miniaturized, a problem in structure also occurs that work for attaching the shield to the substrate is difficult.

### SUMMARY OF THE INVENTION

The invention is made in view of the situation of such prior art and the object is to provide a surface-mounting type electronic circuit unit provided with a shield suitable for miniaturization and easy to manufacture.

To achieve the object, in a surface-mounting type electronic circuit unit according to the invention, thinly formed circuit elements and a semiconductor bare chip bonded via wire are mounted on a substrate having an earth pattern, at least a part of the earth pattern is exposed on the substrate and an insulating passivation layer is formed so that the circuit element and the semiconductor bare chip are covered with the insulating passivation layer, and a shield conducts to the earth pattern and is bonded to the earth pattern in a state in which the shield covers the insulating passivation layer.

According to such a configuration, as the circuit element and the semiconductor bare chip respectively mounted on the substrate using thin-film technology are covered with the insulating passivation layer, circuit components required on the substrate can be precisely and densely mounted and in addition, the shield can be easily attached on the insulating passivation layer as a bonded face.

In the abovementioned configuration, for the shield, metallic foil and a metallic plate formed in a desired shape beforehand can be used and it is desirable that when such a shield is bonded to the insulating passivation layer, the earth pattern and the shield conduct via a conductive adhesive.

Also, in the abovementioned configuration, the insulating passivation layer may also be used as it is, however, it is desirable that after formation, the upper surface of the insulating passivation layer is flattened and when the insulating passivation layer is flattened as described above, metallic foil can be easily and securely bonded to the insulating passivation layer particularly when the metallic foil is used for the shield.

An embodiment of the present invention, will now be described, by way of example only, with reference to the accompanying diagrammatic drawings, in which :
FIG. 1 is a sectional view showing a surface-mounting type electronic circuit unit equivalent to an embodiment of the invention;
FIGs. 2A to 2E are explanatory drawings showing a manufacturing process of the electronic circuit unit; and
FIG. 3 is an exploded perspective view showing a shield and a strip substrate in the middle of the manufacture of the electronic circuit unit.

### DESCRIPTION OF THE PREFERRED EMBODIMENT

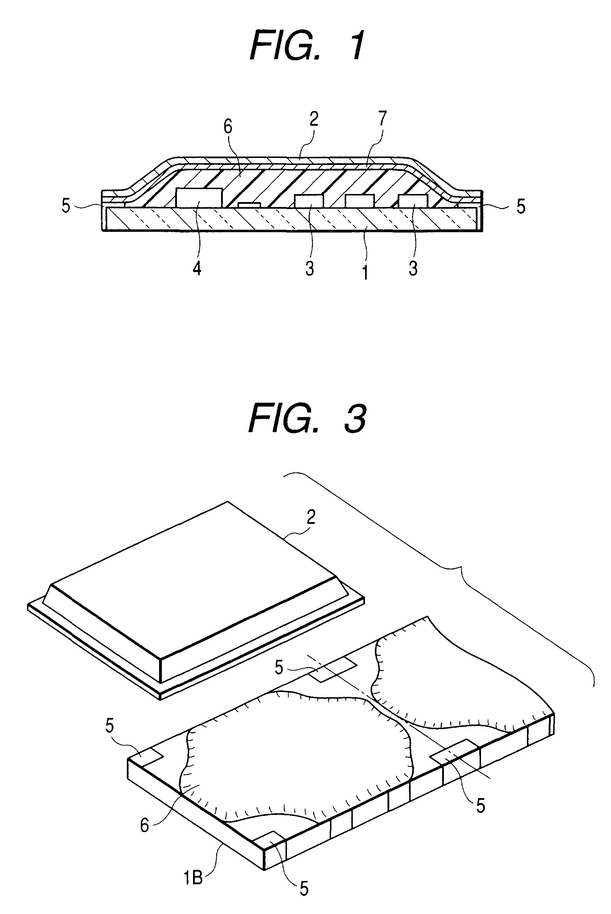

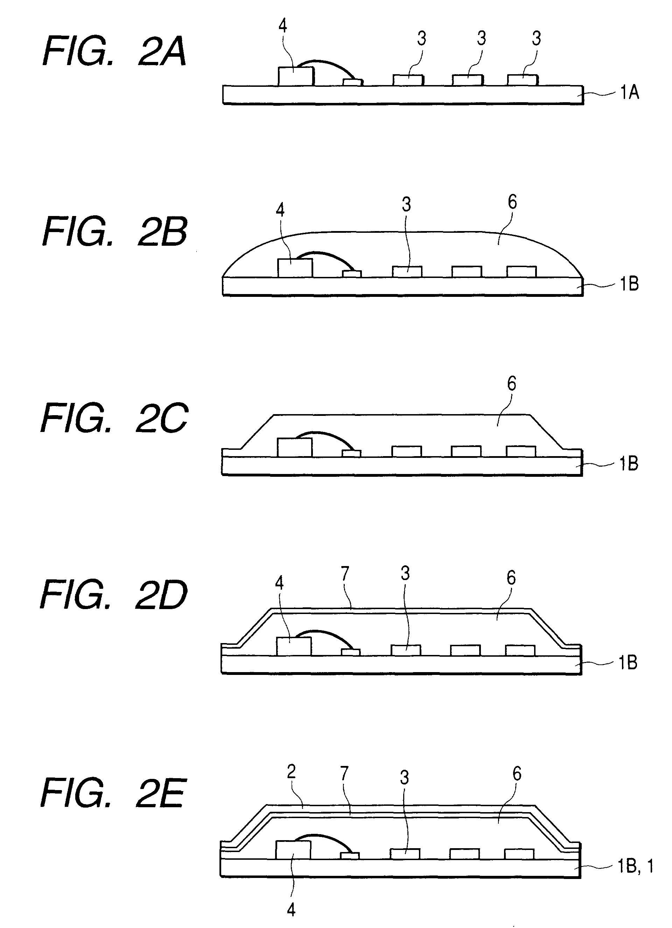

To explain an embodiment of the invention referring to the drawings, FIG. 1 is a sectional view showing a surface-mounting type electronic circuit unit equivalent to an embodiment of the invention, FIGs. 2A to 2E are explanatory drawings showing a manufacturing process of the electronic circuit unit and FIG. 3 is an exploded perspective view showing a shield and a strip substrate in the middle of the manufacture of the electronic circuit unit.

As shown in FIG. 1, the surface-mounting type electronic circuit unit equivalent to this embodiment is a small-sized surface mounting component provided with a substrate 1 made of alumina and a shield 2 that covers circuit components described later and mounted on the substrate 1 and mounted by soldering on a mother board not shown. The substrate 1 is formed so that it is square and flat and is acquired by further subdividing a strip substrate after a large substrate is divided into strip substrates. Circuit elements 3 such as a resistor and a capacitor are formed on the surface of the substrate 1 using thin-film technology such as sputtering, a semiconductor bare chip 4 such as a transistor is bonded to the surface of the substrate 1 via wire and a conductive pattern (not shown) that connects these circuit elements 3 and the semiconductor bare chip 4 is also thinly formed on the surface of the substrate 1. The conductive pattern forms plural end-face electrodes at the edge of the substrate 1 and a part of these end-face electrodes functions as an earth pattern 5.

Also, an insulating passivation layer 6 made of epoxy or silicon is formed on the substrate 1 and the upper surface of the insulating passivation layer 6 is flattened by pressing or polishing. The insulating passivation layer 6 is formed in a region except the earth pattern 5 of the substrate 1, and the circuit elements 3 and the semiconductor bare chip 4 are covered with the insulating passivation layer 6. The shield 2 mentioned above is bonded on the upper surface of the insulating passivation layer 6 using a conductive adhesive 7, the conductive adhesive 7 is also applied on the earth pattern 5, and the shield 2 and the earth pattern 5 conduct via the conductive adhesive 7. The shield 2 is made by forming a metallic thin plate in a desired shape and is formed beforehand so that the shield has substantially the same shape as the flattened insulating passivation layer 6.

Next, mainly referring to FIGs. 2A to 2E and 3, a manufacturing process of the surface-mounting type electronic circuit unit configured as described above will be described.

First, a large substrate made of alumina on which a parting groove extended lengthwise and crosswise is formed is prepared, as shown in FIG. 2A, a circuit element 3 such as a resistor and a capacitor and a conductive pattern including an earth pattern 5 are thinly formed on the large substrate 1A and a semiconductor bare chip 4 such as a transistor is bonded via wire. Next, after the large substrate 1A is cut along a parting groove in one direction and plural strip substrates are acquired, an insulating passivation layer 6 made of epoxy or silicon is formed in a region except the earth pattern 5 on the strip substrate 1B as shown in FIG. 2B, and as shown in FIG. 2C, the upper surface of the insulating passivation layer 6 is flattened by pressing or polishing. Next, as shown in FIG. 2D, after a conductive adhesive 7 is applied on the earth pattern 5 and the insulating passivation layer 6 by printing and others, the shield 2 is bonded on the insulating passivation layer 6 by the conductive adhesive 7 as shown in FIG. 2E by putting the shield 2 on the insulating passivation layer 6 (see FIG. 3), and the shield 2 is electrically connected to the earth pattern 5. Finally, the surface-mounting type electronic circuit unit provided with the shield 2 over an individual substrate 1 shown in FIG. 1 is acquired by subdividing the strip substrate 1B into plural substrates 1 along the other parting groove.

In the embodiment having such a configuration, as the circuit element 3 and the semiconductor bare chip 4 respectively mounted on the substrate 1 using thin-film technology are covered with the insulating passivation layer 6, circuit components required on the substrate 1 can be precisely and densely mounted, and the circuit element 3 and wire can be protected from respectively being damaged and being disconnected by the insulating passivation layer 6. The shield 2 can be easily attached on the insulating passivation layer 6 formed on the substrate as a bonded face and in addition, as the shield 2 is reinforced by the insulating passivation layer 6 and the shield 2 itself does not require large mechanical strength, the shield 2 can be simply formed by a very thin metallic plate. Further, as the bonding to the insulating passivation layer 6 of the shield 2 and the conduction to the earth pattern 5 of the shield 2 are both enabled by the conductive adhesive 7, work for attaching the shield 2 can be simplified.

In the abovementioned embodiment, the case where the shield 2 is attached using the conductive adhesive 7 after the conductive adhesive 7 is applied on the earth pattern 5 and the insulating passivation layer 6 is described, however, conversely, the conductive adhesive 7 is applied on the back side of the shield 2 and the shield 2 can also be attached on the insulating passivation layer 6.

In the abovementioned embodiment, the case where the metallic plate formed in a desired shape beforehand is used for the shield is described, however, metallic foil can also be used for the shield in place of such a metallic plate. At that time, metallic foil cut in the shape of the shield beforehand may also be bonded on the insulating passivation layer, however, when the following metallic foil is subdivided together with the strip substrate 1B and an individual surface-mounting type electronic circuit unit is acquired after tape-shaped metallic foil is bonded on the insulating passivation layer, the manufacturing process can be more simplified.

The invention is embodied in the above-described embodiment and produces the following effect.

As the insulating passivation layer is formed so that it covers the circuit element thinly formed on the substrate and the semiconductor bare chip bonded via wire and the shield bonded on the insulating passivation layer conducts to the earth pattern of the substrate, circuit components required on the substrate can be precisely and densely mounted, the shield can be easily attached using the insulating passivation layer as a bonded face and therefore, the surface-mounting type electronic circuit unit suitable for miniaturization and easy to manufacture can be provided.

## Claims

1. A surface-mounting type electronic circuit unit, wherein:
thinly formed circuit elements and a semiconductor bare chip bonded via wire are mounted on a substrate having an earth pattern;
at least a part of the earth pattern is exposed on the substrate and an insulating passivation layer is formed so that the circuit elements and the semiconductor bare chip are covered with the insulating passivation layer; and
a shield conducts to the earth pattern and is bonded to the earth pattern in a state in which the shield covers the insulating passivation layer.

2. A surface-mounting type electronic circuit unit according to Claim 1, wherein the earth pattern and the shield conduct via a conductive adhesive.

3. A surface-mounting type electronic circuit unit according to Claim 1, wherein the upper surface of the insulating passivation layer is flattened.

4. A surface-mounting type electronic circuit unit according to Claim 2, wherein the upper surface of the insulating passivation layer is flattened.
